# EUROPÄISCHE PATENTSCHRIFT

(11) **EP 2 258 153 B1**
(45) Veröffentlichungstag und Bekanntmachung des Hinweises auf die Patenterteilung: **02.08.2017**
(21) Anmeldenummer: 08734849.6
(22) Anmeldetag: 28.03.2008
(51) Int. Cl.: H05K 7/14

(54) **ELEKTRISCHES BAUKASTENMODULSYSTEM MIT EINEM VARIABEL EINSETZBAREN FELDBUSMODUL**
ELECTRIC MODULAR SYSTEM COMPRISING A MULTI-FUNCTIONAL FIELD BUS MODULE
SYSTÈME MODULAIRE ÉLECTRIQUE COMPRENANT UN MODULE DE BUS DE TERRAIN À UTILISATION VARIABLE

(43) Veröffentlichungstag der Anmeldung: 08.12.2010
(73) Patentinhaber: FESTO AG & Co. KG, 73734 Esslingen (DE)
(72) Erfinder: GRÄFF, Uwe, 73760 Ostfildern (DE); GIENGER, Bernd, 73235 Weilheim (DE)
(74) Vertreter: Patentanwälte Magenbauer & Kollegen Partnerschaft mbB
(86) Internationale Anmeldenummer: PCT/EP2008/002476
(87) Internationale Veröffentlichungsnummer: WO 2009/118028

(56) Entgegenhaltungen:
- EP-A- 1 168 271
- EP-A1- 1 094 228
- EP-A1- 1 577 723
- WO-A1-2006/084294
- DE-A1- 4 412 270
- DE-A1-102005 025 703
- DE-C1- 19 716 137
- DE-U1- 29 807 097
- US-A- 6 008 985

## Beschreibung

Die Erfindung betrifft ein elektrisches Baukastenmodulsystem mit einem Feldbusmodul, das eine Schnittstelle zur Verbindung mit einer entfernten Zentralstation besitzt.

Aus der EP 1595313 B1 ist ein elektrisches Baukastenmodulsystem bekannt, bei dem eine variable Anzahl von E/A-Modulen an ein Basismodul angereiht werden kann, das eine Schnittstelle zu einer entfernten Zentralstation besitzt. Dieses Basismodul ist jedoch mechanisch und elektrisch an die anreihbaren E/A-Module angepasst und für andere Anwendungen nicht geeignet oder vorgesehen.

Die EP 1 577 723 A1 offenbart eine modular aufgebaute Steuerung, insbesondere für Fertigungsanlagen, Maschinen oder dgl., mit einem in einem selbständigen Gehäuse angeordneten Masterbaustein und mindestens einem seitlich neben dem Masterbaustein liegenden, in einem selbständigen Gehäuse angeordneten Slavebaustein, der mit Ein-und/oder Ausgängen zur Verbindung mit Sensoren und/oder Aktoren versehen ist, wobei der Masterbaustein und der Slavebaustein zum Austausch von Daten-und/oder Steuerungsbefehlen über einen Datenbus miteinander kommunizieren, wobei zur Busverbindung der Masterbaustein und der Slavebaustein je eine Schnittstelle aufweisen und wobei die Schnittstelle des Masterbausteins und die Schnittstelle des Slavebausteins
etwa auf gleicher Höhe mit geringem Abstand einander gegenüberliegen und die Schnittstellen drahtlos miteinander in Verbindung stehen.

Die US 6,008,985 offenbart ein Industriecomputersystem zur Steuerung von Produktionsvorgängen, insbesondere im Bereich des Maschinenbaus und der Chemieindustrie. Das Industriecomputersystem umfasst mehrere Feldsteuereinrichtungen, die zu einer Kommunikation mit einer Maschinensteuerung vorgesehen sind. Eine Kommunikationsverbindung zwischen der Maschinensteuerung und den Feldsteuereinrichtungen kann über ein Netzwerk erfolgen. Mit der Feldsteuereinrichtung sind anreihbare E/A-Module verbunden, die zur Kommunikation mit angebauten und/oder entfernten Aktoren und/oder Sensoren ausgebildet sind.

Aus der DE 298 07 097 U1 ist ein elektrofluidisches modulares Baukastensystem bekannt, bei dem mehrere aneinanderreihbare fluidische Module mit einem Schnittstellenmodul verbindbar sind, das als Adapter zwischen einer Busschnittstelle eines ersten Bussystems und einem durch die fluidischen Module durchgeschleiften zweiten Bussystems ausgebildet ist.

Aus der DE 10 2005 025 703 A1 ist Gerätemodul mit zumindest einem Sender, zumindest einem Empfänger und Mitteln zur Erzeugung eines Signals aus einem empfangenen Signal bekannt, mit dem ein Verfahren zur Adressierung, Identifikation und/oder Positionsbestimmung des Gerätemoduls in einer Schaltanlage durchgeführt werden kann. Dabei umfasst das Verfahren die Schritte: Senden eines ersten Signals von einem ersten Modul, Empfangen des ersten Signals durch ein zweites Modul sowie Erzeugen und Senden eines zweiten Signals, welches zu dem ersten Signal in einer vorgegebenen Beziehung steht, vom zweiten Modul an ein drittes Modul, das das vom zweiten Modul gesendete zweite Signal empfängt, Bestimmen der Reihenfolge und/oder Position und/oder Adresse des zumindest einen Moduls durch Auslesen des von dem Modul gesendeten und/oder empfangenen Signals.

Eine Aufgabe der vorliegenden Erfindung besteht darin, ein elektrisches Baukastenmodulsystem zu schaffen, das ein variableres Feldbusmodul besitzt, das für vielseitige Anwendungen bei Beibehaltung von Schnittstellen und Steuerelektronik eingesetzt werden kann.

Diese Aufgabe wird erfindungsgemäß durch ein elektrisches Baukastenmodulsystem mit den Merkmalen des Anspruchs 1 gelöst.

An das erfindungsgemäße Feldbusmodul können bei gleicher elektrischer und mechanischer Schnittstelle unterschiedliche Module angereiht werden, bei denen es sich wenigstens um E/A-Module und/oder Ventilmodule handelt. Weiterhin können auch über eine Kabelschnittstelle über eine Kabelverbindung externe Module und Modulsysteme gesteuert werden. Durch diese universelle Einsetzbarkeit sind Kostenreduzierungen bezüglich der Herstellungskosten, Entwicklungskosten und Lagerhaltungskosten erreichbar. Die Produktfläche für den Hersteller wird vereinfacht. Es können gleichzeitig unterschiedliche angereihte oder entfernte Module gesteuert oder überwacht werden.

Das Feldbusmodul ist in vorteilhafter Weise mit mechanischen Verbindungsmitteln zur Befestigung an einer Halteschiene und/oder an einem fluidischen Anschlussmodul versehen oder verbindbar, wobei die Verbindungsmittel integriert oder als Adapterelemente ausgebildet sein können. Hierdurch sind variable Befestigungsmöglichkeiten an unterschiedlichen Einsatzorten möglich.

Die E/A-Module und/oder Steuermodule der Ventilmodule sind zur variablen Befestigung mit mechanischen Verbindungsmitteln zur Befestigung an einer Halteschiene und/oder an wenigstens einem Fluidikmodul der Ventilmodule versehen.

Die E/A-Module besitzen bevorzugt mehrere Anschlüsse oder Schnittstellen für Aktoren und/oder Sensoren.

Die Modulschnittstelle am Feldbusmodul ist bevorzugt als Gehäusestecker oder Gehäusesteckdose ausgebildet. Diese Modulschnittstelle und auch die Kabelschnittstelle am Feldbusmodul sind in vorteilhafter Weise als kombinierte Bus- und Spannungsversorgungsschnittstelle ausgebildet, so dass alle erforderlichen elektrischen Verbindungen über eine Schnittstelle hergestellt werden können. Dabei eignet sich als Modulschnittstelle und/oder Kabelschnittstelle insbesondere eine M12-Steckverbindung.

Die Ventilmodule und E/A-Module sind aneinander mechanisch und elektrisch anreihbar, so dass beim Anfügen eines weiteren Moduls gleichzeitig die mechanischen und elektrischen Verbindungen hergestellt sind, gegebenenfalls auch fluidische Verbindungen.

Das Feldbusmodul besitzt in vorteilhafter Weise eine einheitliche, zur Steuerung von E/A-Modulen, Ventilmodulen und entfernten Modulen oder Modulsystemen geeignete Steuerelektronik, die somit in variabler Weise alle angeschlossenen Module steuern und/oder weiter mit ihnen kommunizieren kann.

Erfindungsgemäß ist vorgesehen, dass wenigstens ein durch das als Mastermodul arbeitende Feldbusmodul über Kabel steuerbares Modul oder Modulsystem mit einem entsprechenden, als Slavemodul arbeitenden Feldbusmodul versehen ist, wobei die Kabelverbindung zwischen den Feldbusmodulen verläuft. Die große Variabilität des Feldbusmoduls lässt somit einen Einsatz als Mastermodul und als Slavemodul zu. Andererseits können auch hinsichtlich Funktionalität und/oder Schnittstellen bzw. Anschlüssen abgewandelte Feldbusmodule eingesetzt werden.

Das Feldbusmodul enthält zweckmäßigerweise einen programmierbaren Mikrocontroller, in dem ein Feldbusknoten integriert ist oder der mit einem Feldbusknoten versehen ist. Falls erforderlich, kann das Programm des Mikrocontrollers an die jeweiligen Einsatzverhältnisse und Modulkombinationen angepasst werden.

Ausführungsbeispiele der Erfindung ist in der Zeichnung dargestellt und in der nachfolgenden Beschreibung näher erläutert. Es zeigen:
- Figur 1: ein Feldbusmodul als Mastermodul, das über zwei weitere Feldbusmodule als Slavemodule eine entfernte E/A-Modulbatterie und eine entfernte kombinierte E/A-Modulbatterie und Ventilmodulbatterie steuert,
- Figur 2: ein direkt an eine kombinierte Modulbatterie angereihtes Feldbusmodul,
- Figur 3: ein direkt an eine E/A-Modulbatterie angereihtes Feldbusmodul und
- Figur 4: ein direkt an eine Ventilmodulbatterie angereihtes Feldbusmodul.

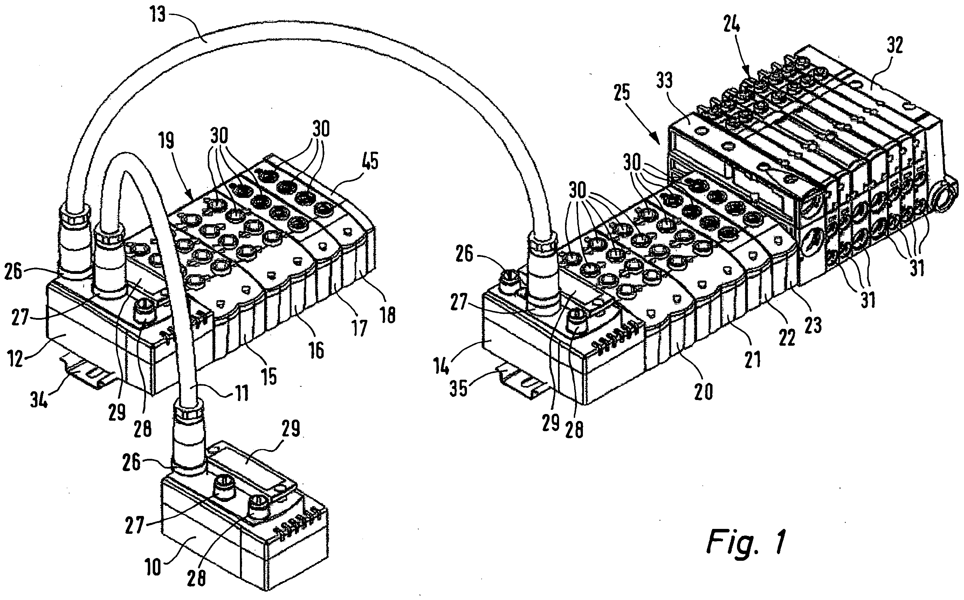

Bei dem in Figur 1 dargestellten Ausführungsbeispiel ist ein als Mastermodul ausgebildetes erstes Feldbusmodul 10 als separates Modul über ein Verbindungskabel 11 mit einem zweiten, als Slavemodul ausgebildeten Feldbusmodul 12 verbunden, das wiederum über ein weiteres Verbindungskabel 13 mit einem dritten, ebenfalls als Slavemodul ausgebildeten Feldbusmodul 14 verbunden ist. An das zweite Feldbusmodul 12 sind vier E/A-Module 15-18 angereiht und bilden somit in Verbindung mit dem zweiten Feldbusmodul 12 eine vom ersten Feldbusmodul 10 aus steuerbare E/A-Modulbatterie 19. An das dritte Feldbusmodul 14 sind vier E/A-Module 20-23 und an diese eine Ventilmodulbatterie 24 angereiht, die zusammen mit den E/A-Modulen 20-23 und dem dritten Feldbusmodul 14 eine kombinierte E/A- und Ventilmodulbatterie 25 bilden.

Die Feldbusmodule 10, 12 und 14 besitzen jeweils drei Kabelanschlüsse 26-28, bei denen es sich beispielsweise um normierte M12-Stecker beziehungsweise M12-Steckaufnahmen handeln kann. Die Zahl und Ausführung dieser Kabelanschlüsse 26-28 kann selbstverständlich variiert werden. Beim dargestellten Ausführungsbeispiel handelt es sich beim Kabelanschluss 26 um einen Ausgangsanschluss, beim Kabelanschluss 27 um einen Eingangsanschluss und beim Kabelanschluss 28 um einen Versorgungsanschluss zur Zuführung der erforderlichen Betriebsspannung beziehungsweise der erforderlichen Betriebsspannungen. Alternativ hierzu kann es sich beim Kabelanschluss 28 auch um eine Schnittstelle zu einer entfernten Zentralstation beziehungsweise Steuerzentrale handeln, von der aus auch die erforderlichen Betriebsspannungen im gleichen Kabel zugeführt werden können. Die Spannungsversorgung des zweiten Feldbusmoduls 12 und des dritten Feldbusmoduls 14 kann direkt über die entsprechenden Kabelanschlüsse 28 erfolgen oder aber vom Feldbusmodul 10 aus über die Verbindungskabel 11 und 13, die neben Daten- beziehungsweise Steuerleitungen auch Spannungsversorgungsleitungen enthalten können. Dabei sind auch Busleitungen möglich, über die gleichzeitig die Spannungsversorgung erfolgt.

Die Feldbusmodule 10, 12 und 14 besitzen an der Oberseite eine abnehmbare oder aufklappbare Abdeckung 29, unter der Bedien- und/oder Anzeigeelemente angeordnet sein können. Zusätzlich können bei Bedarf noch weitere Schnittstellen dort vorgesehen sein. Eine derartige Abdeckung 29 kann prinzipiell auch entfallen. Weiterhin können die beschriebenen Kabelanschlüsse 26-28 auch eine andere Funktionalität als die jeweils beschriebene Funktionalität aufweisen und auch die Zahl und Anordnung der Kabelanschlüsse bzw. Schnittstellen kann variieren. Die als Slavemodule arbeitenden Feldbusmodule 12 und 14 können entsprechend dem ersten Feldbusmodul ausgebildet sein oder sie können sich auch hinsichtlich Funktionalität und der Anschlüsse von diesem unterscheiden.

Die an das zweite Feldbusmodul 12 und dritte Feldbusmodul 14 angereihten E/A-Module 15-18 beziehungsweise 20-23 weisen verschiedene Breiten auf, wobei auch noch weitere Breitendimensionen möglich sind. An ihrer Oberseite sind jeweils mehrere Schnittstellen 30 angeordnet, bei denen es sich um Busschnittstellen oder übliche Steckdosen handeln kann. Hierdurch können externe Aktoren und/oder Sensoren angeschlossen werden, um über das als Mastermodul ausgebildete erste Feldbusmodul 10 oder auch wenigstens teilweise über die jeweils direkt angereihten, als Slavemodul fungierenden Feldbusmodule 12 und 14 gesteuert zu werden oder um mit diesen kommunizieren zu können. Auch die einzelnen E/A-Module 15-18 beziehungsweise 20-23 können prinzipiell Steuer- und/oder Kommunikationsmittel enthalten und wenigstens teilweise Steuer- und Kommunikationsfunktionen übernehmen. Falls das erste Feldbusmodul 10 über seinen Kabelanschluss 27 als Eingangsanschluss mit einer externen Zentralstation oder Steuerzentrale verbunden sein sollte, so können Steuer- und/oder Kommunikationsfunktionen auch von dort aus ausgeübt werden.

Die breiteren E/A-Module 15, 16, 20, 21 besitzen jeweils acht Schnittstellen 30, während die übrigen E/A-Module 17, 18, 22, 23 jeweils nur vier Schnittstellen 30 besitzen. Die Zahl der Schnittstellen 30 kann selbstverständlich variieren.

An den E/A-Modulen 20-23, die mit dem dritten Feldbusmodul 14 verkettet sind, ist die Ventilmodulbatterie 24 angereiht, die sieben Ventilmodule 31 aufweist. Diese Ventilmodule 31 sind plattenartig aneinandergereiht und am freien Ende durch ein Fluidikanschlussmodul 32 abgeschlossen. Über dieses können die erforderlichen, jedoch nicht dargestellten Fluidikleitungen angeschlossen werden. Zwischen den Ventilmodulen 31 und den E/A-Modulen 20-23 ist ein Adaptermodul 33 angeordnet. Dieses schließt zum einen die fluidischen Leitungen durch die Ventilmodule 31 gegenüber den E/A-Modulen 20-23 ab und verbindet quer durch die E/A-Module 20-23 verlaufende Steuer-, Daten- und Versorgungsleitungen mit entsprechenden, quer durch die Ventilmodule 31 verlaufenden Leitungen. Um derartige Leitungen von Modul zu Modul weiterzuführen, besitzen die E/A-Module 15-18 sowie 20-23 und die Ventilmodule 31 jeweils an ihren gegenüberliegenden Anlageseiten Steckverbindungen, so dass beim Zusammenreihen der Module automatisch die elektrischen Verbindungen hergestellt werden.

Die Feldbusmodule 10, 12 und 14 besitzen in nicht dargestellter und infolge der perspektivischen Darstellung nicht ersichtlicher Weise als Steckverbindungen ausgebildete Schnittstellen, um in variabler Weise E/A-Module 15-18, 20-23 oder Ventilmodule 31 so anreihen zu können, dass die erforderlichen elektrischen Verbindungen automatisch hergestellt werden. Bei ersten Feldbusmodul 10 ist die entsprechende Schnittstelle nicht verwendet, da keine Module angereiht sind. Sie kann beispielsweise durch eine Abdeckung abgedeckt werden.

Die Feldbusmodule 10, 12, 14 enthalten eine beispielsweise als Mikrocontroller ausgebildete elektronische Einrichtung, um zum einen die Steuer- und Kommunikationsaufgaben erfüllen zu können und um zum anderen gegebenenfalls über Busleitungen ankommende Signale und gegebenenfalls über Busleitungen abgehende Signale entsprechend konfigurieren zu können. Der Mikrocontroller erfüllt dadurch auch die Funktion eines Busknotens, wobei auch separate Busknoten enthalten sein können. Wesentlich ist dabei, dass die elektronische Einrichtung alle vorkommenden Funktionen erfüllen kann, um in variabler Weise unterschiedliche Module steuern zu können und mit ihnen kommunizieren zu können.

Die E/A-Modulbatterie 19 und die E/A- und Ventilmodulbatterie 25 sind jeweils auf einer Halteschiene 34, 35 angeordnet, das heißt, alle Module besitzen an der Unterseite entsprechende Schienenaufnahmen oder Adapterelemente zur Befestigung an den Halteschienen 34, 35. Die Befestigung an Halteschienen 34, 35 ist selbstverständlich optional.

Es ist auch möglich, dass eines der Feldbusmodule 12 oder 14 die Funktion als Mastermodul übernimmt und das jeweils andere Feldbusmodul beziehungsweise die daran angeschlossene Modulbatterie steuert. In diesem Falle kann das erste separate Feldbusmodul 10 entfallen. Das dann als Mastermodul arbeitende Feldbusmodul, beispielsweise das Feldbusmodul 12, steuert dann sowohl die angeschlossenen E/A-Module 15-18 als auch die E/A- und Ventilmodulbatterie 25 und kommuniziert mit diesen Einheiten.

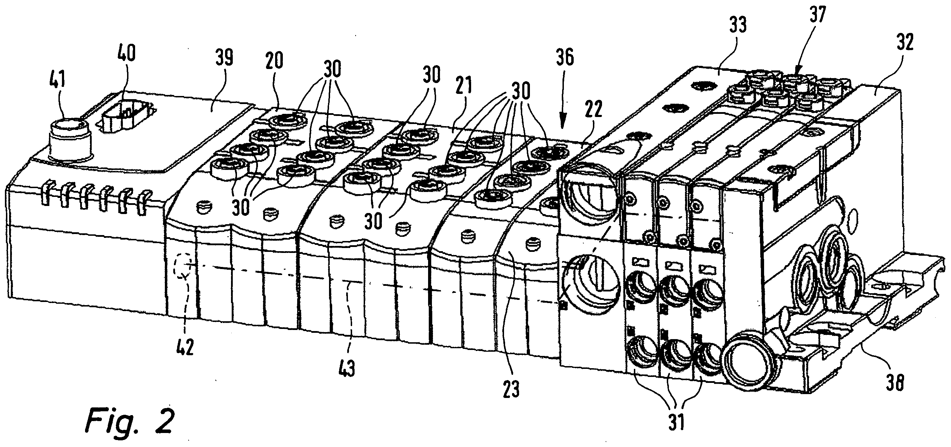

In Figur 2 ist eine geringfügig modifizierte E/A- und Ventilmodulbatterie 36 dargestellt. In Abweichung der in Figur 1 dargestellten E/A- und Ventilmodulbatterie 25 besitzt der Bereich der Ventilmodulbatterie 37 nur drei Ventilmodule 31, während die E/A-Module 20-23 beibehalten sind. Am Fluidikanschlussmodul 32 ist unten die schwalbenschwanzartige Aufnahme 38 für Halteschienen 34, 35 erkennbar. Ein abgewandeltes Feldbusmodul 39 besitzt lediglich eine Multipol-Steckdose 40 als Busanschluss und einen Kabelanschluss 41 als Schnittstelle, der beispielsweise als M12-Steckdose ausgebildet sein kann. Die Multipol-Steckdose 40 dient beispielsweise als BusSchnittstelle zu einer entfernten Zentralstation, über die auch die Spannungsversorgung erfolgen kann. Der Kabelanschluss 41 dient als Steuerausgang zur Steuerung von entfernten Modulen oder Modulsystemen über ein Kabel, wie dies beispielsweise in Figur 1 dargestellt ist oder er dient als Spannungsversorgungsanschluss. Beide Anschüsse 41 und 40 können selbstverständlich auch anders konfiguriert und für andere Eingangs- und/oder Ausgangssignale angepasst werden Oder es sind bei Bedarf noch weitere Anschlüsse bzw. Schnittstellen vorgesehen. Das Feldbusmodul 10 gemäß Figur 1 kann selbstverständlich auch hier eingesetzt werden.

An der Seitenfläche des Feldbusmoduls 39, an der die E/A-Module 20-23 angereiht sind, ist eine in Figur 2 nur schematisch dargestellte Schnittstelle 42 angeordnet, die beispielsweise als M12-Steckverbindung oder andere mehrpolige Steckverbindung ausgebildet sein kann und von der aus Leitungen 43 quer durch die E/A-Module 20-23 und die Ventilmodule 31 verlaufen. Bei diesen Leitungen handelt es sich um Steuer- und Datenleitungen sowie Spannungsversorgungsleitungen. Die Steuer- und Datenleitungen können beispielsweise als Busleitungen ausgebildet sein. Von Modul zu Modul werden diese Leitungen 43 über nicht dargestellte Steckverbindungen an den jeweiligen Kontaktflächen der Module weitergeführt.

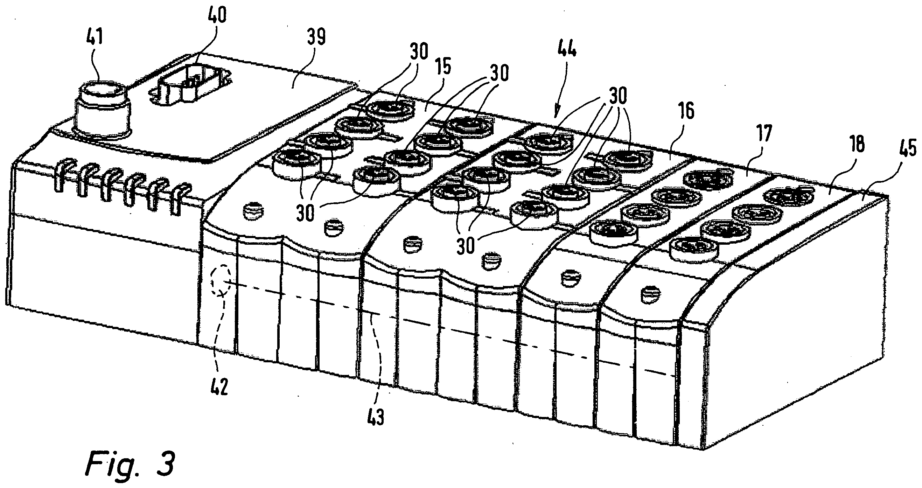

Die in Figur 3 dargestellte E/A-Modulbatterie 44 entspricht weitgehend der in Figur 1 dargestellten E/A-Modulbatterie 19, so dass gleiche oder gleichwirkende Bauteile und Module nicht nochmals beschrieben sind. Anstelle des Feldbusmoduls 12 gemäß Figur 1 tritt hier das Feldbusmodul 39, das auch bei der in Figur 2 dargestellten E/A- und Ventilmodulbatterie 37 verwendet wurde. Selbstverständlich kann auch hier z.B. das Feldbusmodul 10 gemäß Figur 1 eingesetzt werden. Die E/A-Module 20-23 sind an ihrem vom Feldbusmodul 39 entfernten Ende durch ein Abschlusselement 45 abgeschlossen, das auch bei der in Figur dargestellten E/A-Modulbatterie 19 vorgesehen ist.

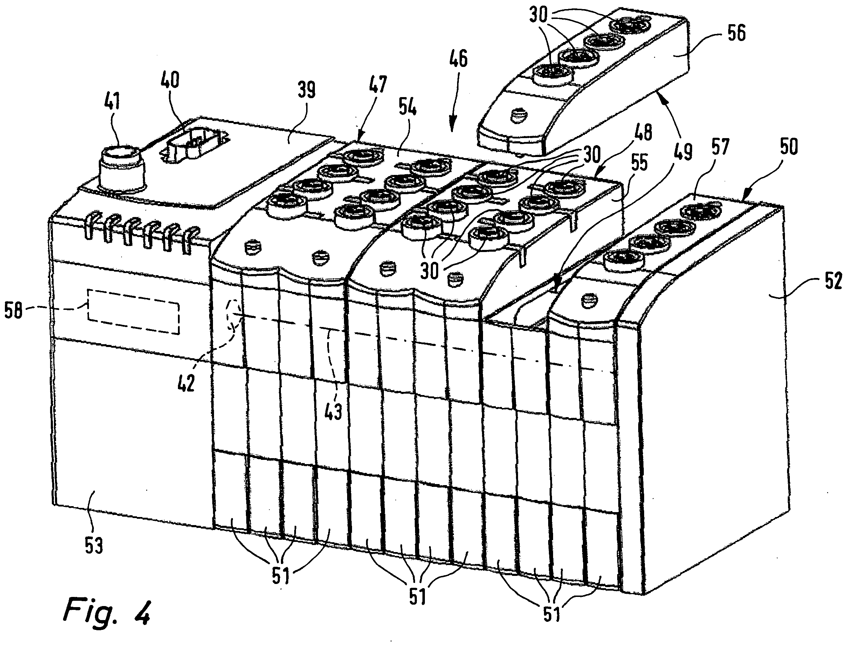

Bei der in Figur 4 dargestellten Ventilmodulbatterie 46 ist wiederum das Feldbusmodul 39 eingesetzt. Daran angereiht sind vier E/A-Module 47-50, die gleichzeitig zur Steuerung der darunter angeordneten fluidischen Ventilbereiche 51 dienen. Diese zwölf fluidischen Ventilbereiche 51 bilden zusammen mit den vier E/A-Modulen 47-50 zwölf fluidische Magnetventile. Dabei steuern die E/A-Module 47, 48 jeweils vier fluidische Ventilbereiche 51 und die E/A-Module 49, 50 je zwei fluidische Ventilbereiche 51. Die E/A-Module 47-50 enthalten hierzu entsprechende Steuermittel und können auch nicht dargestellte fluidische Vorsteuerventile für die fluidischen Ventilbereiche 51 enthalten. Zusätzlich können über die Schnittstellen 30 externe Sensoren und/oder Aktoren angeschlossen werden. Die Ventilmodulbatterie 46 ist durch ein Abschlusselement 52 abgeschlossen. Das Feldbusmodul 39 ist auf einem Unterblock 53 aufgesetzt, der in Reihe zu den fluidischen Ventilbereichen 51 angeordnet ist. Er dient beispielsweise als fluidischer Anschlussblock und kann mit fluidischen Zufuhr- und/oder Auslassleitungen verbunden werden.

Die E/A-Module 47-50 können von den fluidischen Ventilbereichen 51 abgenommen werden und sind an diesen mittels Haltevorrichtungen, wie Schrauben oder Rastelementen, befestigt. Mit den Schnittstellen 30 versehene Deckelelemente 54-57 der E/A-Module 47-50 können ebenfalls abgenommen werden und beispielsweise durch solche ersetzt werden, die keine Schnittstellen 30 besitzen. Sofern solche Schnittstellen 30 nicht benötigt werden, kann dadurch eine Kosteneinsparung erreicht werden. Die Deckelelemente 54-57 können über nicht dargestellte elektrische Steckverbindungen elektrisch mit den Leitungen 43 oder mit ebenfalls nicht dargestellten elektronischen Einrichtungen in den E/A-Modulen 47-50 verbunden sein, sofern solche vorgesehen sind.

Anstelle der beschriebenen Ventilanordnungen können auch andere bekannte aneinanderreihbare fluidische Magnetventile treten, insbesondere Plattenventile.

Auch die Ventilmodulbatterie 46 beziehungsweise deren Module können in nicht dargestellter Weise an einer Halteschiene fixiert werden.

Die Kommunikation von Feldbusmodulen mit entfernten Modulen oder Modulsystemen kann auch drahtlos erfolgen.

Zur variablen Ausgestaltung des beschriebenen Baukastensystems besitzt das oder die jeweiligen Feldbusmodule 10, 12, 14, 39 einen Mikrocontroller 58, der zur Vereinfachung lediglich im Feldbusmodul 39 gemäß Figur 4 schematisch dargestellt ist. In diesem Mikrocontroller ist wenigstens ein Feldbusknoten integriert, der an das jeweils verwendete Bussystem oder die jeweils verwendeten Bussysteme angepasst ist. Dieser wenigstens eine Feldbusknoten kann auch als separate Einrichtung ausgebildet sein. Der Mikrocontroller enthält alle Steuer-, Kommunikations- und gegebenenfalls Diagnosefunktionen, die für alle möglichen direkt oder über Kabel anschließbaren Module, Modulsysteme oder sonstigen elektronischen Einrichtungen geeignet und erforderlich sind. Dabei kann der Mikrocontroller über die jeweiligen Schnittstellen die angeschlossenen Module oder elektrischen Einrichtungen automatisch erfassen und entsprechende geeignete Steuerfunktionen bereitstellen.

## Patentansprüche

1. Elektrisches Baukastenmodulsystem mit einem variabel einsetzbaren Feldbusmodul (10, 12, 14; 39), das eine Schnittstelle (27; 40) zur Verbindung mit einer entfernten Zentralstation besitzt, mit an das Feldbusmodul (12, 14; 39) anreihbaren E/A-Modulen (15-18, 20-23; 47-50) zur Verbindung mit angebauten und/oder entfernten Aktoren und/oder Sensoren, mit an das Feldbusmodul (14; 39) mechanisch und elektrisch anreihbaren Ventilmodulen (31: 51) einer elektromagnetischen Ventilbatterie (24; 37; 46), mit einer Modulschnittstelle (42) am Feldbusmodul (10, 12, 14; 39) zur elektrischen Verbindung mit angereihten E/A-Modulen (15-18, 20-23; 47-50) und/oder Ventilmodulen (31; 51) und mit einer Kabelschnittstelle (26; 41) zur Kabelverbindung mit entfernten, durch das Feldbusmodul steuerbaren Modulen oder Modulsystemen, wobei wenigstens ein durch das als Mastermodul arbeitende Feldbusmodul (10) über Kabel (11, 13) steuerbares Modul oder Modulsystem (19, 25) mit einem entsprechenden, als Slavemodul arbeitenden Feldbusmodul (12, 14) versehen ist, wobei die Kabelverbindung zwischen den Feldbusmodulen verläuft und wobei wenigstens ein Feldbusmodul (12, 14) derart ausgebildet ist, dass es als Mastermodul und als Slavemodul einsetzbar ist.

2. Baukastenmodulsystem nach Anspruch 1, **dadurch gekennzeichnet, dass** das Feldbusmodul (10, 12, 14; 39) mit mechanischen Verbindungsmitteln zur Befestigung an einer Halteschiene (34, 35) und/oder an einem fluidischen Anschlussmodul (53) versehen oder verbindbar ist, wobei die Verbindungsmittel integriert oder als Adaptermittel ausgebildet sein können

3. Baukastenmodulsystem nach Anspruch 1 oder 2, **dadurch gekennzeichnet, dass** die E/A-Module (15-18, 20-23) und/oder Steuermodule (47-50) der Ventilmodule (51) mit mechanischen Verbindungsmitteln zur Befestigung an einer Halteschiene (34, 35) und/oder an wenigstens einem Fluidikmodul der Ventilmodule (51) versehen ist.

4. Baukastenmodulsystem nach einem der vorhergehenden Ansprüche, **dadurch gekennzeichnet, dass** die E/A-Module (15-18, 20-23; 47-50) bevorzugt Anschlüsse oder Schnittstellen (30) für Aktoren und/oder Sensoren besitzen.

5. Baukastenmodulsystem nach einem der vorhergehenden Ansprüche, **dadurch gekennzeichnet, dass** die Modulschnittstelle (42) am Feldbusmodul (10, 12, 14; 39) als Gehäusestecker oder Gehäusesteckdose ausgebildet ist.

6. Baukastenmodulsystem nach einem der vorhergehenden Ansprüche, **dadurch gekennzeichnet, dass** die Modulschnittstelle (42) und Kabelschnittstelle (26; 41) am Feldbusmodul (10, 12, 14; 39) als kombinierte Bus- und Spannungsversorgungsschnittstelle ausgebildet ist.

7. Baukastenmodulsystem nach Anspruch 6, **dadurch gekennzeichnet, dass** die Modulschnittstelle (42) und/oder Kabelschnittstelle (26; 41) als M12-Steckverbindung ausgebildet ist.

8. Baukastenmodulsystem nach einem der vorhergehenden Ansprüche, **dadurch gekennzeichnet, dass** die Ventilmodule (31; 51) und E/A-Module (15-18, 20-23; 47-50) aneinander mechanisch und elektrisch anreihbar sind.

9. Baukastenmodulsystem nach einem der vorhergehenden Ansprüche, **dadurch gekennzeichnet, dass** das Feldbusmodul (10, 12, 14; 39) eine einheitliche zur Steuerung von E/A-Modulen (15-18, 20-23; 47-50), Ventilmodulen (31; 51) und entfernten Modulen oder Modulsystemen (19, 25) geeignete Steuerelektronik aufweist.

10. Baukastenmodulsystem nach einem der vorhergehenden Ansprüche, **dadurch gekennzeichnet, dass** das Feldbusmodul (10, 12, 14; 39) einen programmierbaren Mikrocontroller (51) und wenigstens einen Feldbusknoten enthält, der vorzugsweise im Mikrocontroller (58) integriert ist.

## Claims

1. Electrical building block modular system, with a field bus module (10, 12, 14; 39) suitable for variable use and having an interface (27; 40) for connection with a remote central station, with I/O modules (15-18, 20-23; 47-50) mountable side-by-side on the field bus module (12, 14; 39) for connection with attached and/or remote actuators and/or sensors, with valve modules (31; 51) of an electromagnetic valve bank (24; 37; 46), mountable side-by-side mechanically and electrically on the field bus module (14; 39), with a module interface (42) on the field bus module (10, 12, 14; 39) for electrical connection with I/O modules (15-18, 20-23; 47-50) and/or valve modules (31; 51) mounted side-by-side, and with a cable interface (26; 41) for cable connection with remote modules or modular systems controllable by the field bus module, wherein at least one module or modular system controllable by cable (11, 13) by the field bus module (10) operating as master module is provided with a corresponding field bus module (12, 14) operating as slave module, wherein the cable connection runs between the field bus modules and wherein at least one field bus module (12, 14) is so designed that it may be used as master module and as slave module.

2. Building block modular system according to claim 1, **characterised in that** the field bus module (10, 12, 14; 39) is provided with or may be connected to mechanical connection means for attaching to a mounting rail (34, 35) and/or to a fluidic connection module (53),wherein the connection means may be integrated or in the form of adapter means.

3. Building block modular system according to claim 1 or 2, **characterised in that** the I/O modules (15-18, 20-23) and/or control modules (47-50) of the valve modules (51) are provided with mechanical connection means for attaching to a mounting rail (34, 35) and/or to at least one fluidic module of the valve modules (51).

4. Building block modular system according to any of the preceding claims, **characterised in that** the I/O modules (15-18, 20-23; 47-50) preferably have connections or interfaces (30) for actuators and/or sensors.

5. Building block modular system according to any of the preceding claims, **characterised in that** the module interface (42) is formed as casing plug or casing socket on the field bus module (10, 12, 14; 39).

6. Building block modular system according to any of the preceding claims, **characterised in that** the module interface (42) and cable interface (26; 41) are formed on the field bus module (10, 12, 14; 39) as a combined bus and power supply interface.

7. Building block modular system according to claim 6, **characterised in that** the module interface (42) and/or cable interface (26; 41) are in the form of an M12 plug connector.

8. Building block modular system according to any of the preceding claims, **characterised in that** the the valve modules (31; 51) and I/O modules (15-18, 20-23; 47-50) are mountable mechanically and electrically side-by-side.

9. Building block modular system according to any of the preceding claims, **characterised in that** the field bus module (10, 12, 14; 39) has unified control electronics suitable for control of I/O modules (15-18, 20-23; 47-50), valve modules (31; 51) and remote modules or modular systems (19, 25).

10. Building block modular system according to any of the preceding claims, **characterised in that** the field bus module (10, 12, 14; 39) contains a programmable microcontroller (51) and at least one field bus node, which is preferably integrated in the microcontroller (58).

## Revendications

1. Système électrique modulaire avec un module de bus de terrain (10, 12, 14 ; 39) à utilisation variable qui possède une interface (27 ; 40) pour la connexion avec une station centrale distante, avec des modules d'entrée/sortie (15-18, 20-23 ; 47-50) pouvant être mis en jonction avec le module de bus de terrain (12, 14 ; 39) pour la connexion avec des acteurs et/ou capteurs annexés et/ou distants, avec des modules de soupape (31 ; 51), pouvant être mis en jonction mécanique et électrique avec le module de bus de terrain (14 ; 39), d'une batterie de soupapes électromagnétiques (24 ; 37 ; 46), avec une interface de module (42) au niveau du module de bus de terrain (10, 12, 14 ; 39) pour la connexion électrique avec des modules d'entrée/sortie (15-18, 20-23 ; 47-50) et/ou modules de soupape (31 ; 51) mis en jonction, et avec une interface de câble (26 ; 41) pour la connexion par câble avec des modules ou systèmes modulaires distants pouvant être commandés par le module de bus de terrain, dans lequel au moins un module ou système modulaire (19, 25) pouvant être commandé par câble (11, 13) par le module de bus de terrain (10) travaillant en tant que module maître est doté d'un module de bus de terrain (12, 14) correspondant travaillant en tant que module esclave, dans lequel la connexion par câble s'étend entre les modules de bus de terrain et dans lequel au moins un module de bus de terrain (12, 14) est réalisé de telle manière qu'il peut être utilisé en tant que module maître et en tant que module esclave.

2. Système modulaire selon la revendication 1, **caractérisé en ce que** le module de bus de terrain (10, 12, 14 ; 39) est doté de moyens de connexion mécanique, ou peut-être connecté à ceux-ci, pour la fixation à un rail de support (34, 35) et/ou à un module de connexion fluidique (53), dans lequel les moyens de connexion peuvent être intégrés ou réalisés en tant que moyens d'adaptation.

3. Système modulaire selon la revendication 1 ou 2, **caractérisé en ce que** les modules d'entrée/sortie (15-18, 20-23) et/ou les modules de commande (47-50) des modules de soupape (51) sont dotés de moyens de connexion mécanique pour la fixation à un rail de support (34, 35) et/ou à au moins un module fluidique des modules de soupape (51).

4. Système modulaire selon l'une des revendications précédentes, **caractérisé en ce que** les modules d'entrée/sortie (15-18, 20-23; 47-50) possèdent de préférence des connexions ou interfaces (30) pour des actionneurs et/ou capteurs.

5. Système modulaire selon l'une des revendications précédentes, **caractérisé en ce que** l'interface de module (42) au niveau du module de bus de terrain (10, 12, 14 ; 39) est réalisée en tant que connecteur à boîtier ou prise de courant à boîtier.

6. Système modulaire selon l'une des revendications précédentes, **caractérisé en ce que** l'interface de module (42) et l'interface de câble (26 ; 41) au niveau du module de bus de terrain (10, 12, 14 ; 39) sont réalisées en tant qu'interface combinée de bus et d'alimentation en tension.

7. Système modulaire selon la revendication 6, **caractérisé en ce que** l'interface de module (42) et/ou l'interface de câble (26 ; 41) est réalisée en tant que connexion enfichable M12.

8. Système modulaire selon l'une des revendications précédentes, **caractérisé en ce que** les modules de soupape (31 ; 51) et les modules d'entrée/sortie (15-18, 20-23 ; 47-50) peuvent être mis en jonction électrique et mécanique les uns avec les autres.

9. Système modulaire selon l'une des revendications précédentes, **caractérisé en ce que** le module de bus de terrain (10, 12, 14 ; 39) présente une électronique de commande homogène adaptée pour la commande de modules d'entrée/sortie (15-18, 20-23 ; 47-50), de modules de soupape (31 ; 51) et de modules ou de systèmes de module (19, 25) distants.

10. Système modulaire selon l'une des revendications précédentes, **caractérisé en ce que** le module de bus de terrain (10, 12, 14 ; 39) contient un microcontrôleur programmable (51) et au moins un noeud de bus de terrain qui est de préférence intégré dans le microcontrôleur (58).
